(19) Europäisches Patentamt
European Patent Office
Office européen des brevets

(11) **EP 4 270 085 B1**

(12) **EUROPEAN PATENT SPECIFICATION**

(45) Date of publication and mention
of the grant of the patent:
**26.03.2025 Bulletin 2025/13**

(21) Application number: **23167694.1**

(22) Date of filing: **13.04.2023**

(51) International Patent Classification (IPC):
**G02B 26/08** (2006.01)

(52) Cooperative Patent Classification (CPC):
**G02B 26/0833**

(54) **OPTICAL SCANNING DEVICE AND ABNORMALITY DETECTION METHOD**

OPTISCHE ABTASTVORRICHTUNG UND ANOMALIEDETEKTIONSVERFAHREN

DISPOSITIF DE BALAYAGE OPTIQUE ET PROCÉDÉ DE DÉTECTION D'ANOMALIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **28.04.2022 JP 2022075199**

(43) Date of publication of application:
**01.11.2023 Bulletin 2023/44**

(73) Proprietor: **FUJIFILM Corporation**
**Tokyo 106-8620 (JP)**

(72) Inventors:
• **ABE, Masaaki**
**Kaisei (JP)**
• **NAONO, Takayuki**
**Kaisei (JP)**
• **NISHIURA, Yosuke**
**Kaisei (JP)**

(74) Representative: **HGF**
**HGF Limited**
**1 City Walk**
**Leeds LS11 9DX (GB)**

(56) References cited:
**JP-A- 2004 144 926    US-A1- 2006 175 544**

**Description**

BACKGROUND OF THE INVENTION

1. Field of the Invention

The technology of the present disclosure relates to an optical scanning device and an abnormality detection method.

2. Description of the Related Art

A micromirror device (also referred to as a microscanner) is known as one of micro electro mechanical systems (MEMS) devices manufactured using a silicon (Si) nanofabrication technique. A mirror and an actuator that allows the mirror to swing are formed in the micromirror device. Since this micromirror device has a small size and low power consumption, the micromirror device is used in a laser scanner such as light detection and ranging (LiDAR) or head-up display (HUD).

In the laser scanner such as LiDAR or HUD, it is important to ensure user safety. For example, in a case in which an operation of the mirror is stopped in a state in which an output of laser light from a light source is on, it is dangerous because the laser light is continuously emitted to the same position. Therefore, it is required to detect an abnormal operation of the mirror during the operation. In order to detect the abnormal operation of the mirror, it is necessary to accurately detect a deflection angle of the mirror during the operation of the mirror.

JP2004-170499A discloses a method of detecting a deflection angle of a mirror by irradiating a back surface of a mirror with light, receiving the light reflected by the mirror with a light-receiving element, and calculating an output signal of the light-receiving element. Documents JP 2004 144926 A and US 2006/175544 A1 are relevant prior art to the present invention.

SUMMARY OF THE INVENTION

Although JP2004-170499A discloses the detection of the deflection angle of the mirror, it does not disclose detection of an abnormal operation of the mirror. In order to detect the abnormal operation of the mirror, a method of monitoring an amplitude of the mirror and determining that the abnormal operation has occurred in a case in which the amplitude falls outside a predetermined range is considered. However, since there is a need to acquire and evaluate a waveform for one swing period in order to detect the amplitude of the mirror, the abnormal operation of the mirror cannot be detected at high speed.

An object of the technology of the present disclosure is to provide an optical scanning device and an abnormality detection method with which an abnormal operation of a mirror can be detected at high speed during the operation.

In order to achieve the above object, an optical scanning device of the present disclosure comprises: a micromirror device including a mirror that has a reflecting surface for reflecting light and is swingable around at least one axis, and an actuator that allows the mirror to swing; a control device configured to control an operation of the actuator; a light irradiation device configured to irradiate a back surface of the mirror on a side opposite to the reflecting surface with illumination light; a detection device to which reflected light of the illumination light that has been reflected by the mirror is incident and configured to output a position signal representing a position of the incidence light; and an abnormality detection device configured to detect an abnormal operation of the mirror based on a temporal fluctuation amount of the position signal.

It is preferable that the detection device is a position sensitive detector capable of detecting a light quantity centroid position of the incidence light, and that the position signal represents the light quantity centroid position.

It is preferable that the control device causes the mirror to resonate with a fixed swing period by driving the actuator.

It is preferable that the abnormality detection device detects an amount by which the position signal fluctuates in a time interval smaller than 5% of the swing period, as the fluctuation amount.

It is preferable that the abnormality detection device detects an amount by which the position signal fluctuates in a time interval smaller than 5% and larger than 0.05% of the swing period, as the fluctuation amount.

It is preferable that the abnormality detection device includes a detection part configured to detect the fluctuation amount and a determination part configured to determine whether or not the fluctuation amount is equal to or greater than a threshold value.

It is preferable that the detection part is configured of a delay circuit that delays the position signal output from the detection device by a certain period of time, and a differential amplification circuit that amplifies and outputs a difference between the position signal output from the detection device and the position signal delayed by the delay circuit.

It is preferable that the determination part is a comparator.

It is preferable that the detection device is a position sensitive detector capable of simultaneously detecting the light quantity centroid position and an intensity of light of the incidence light, and that the abnormality detection device detects the abnormal operation based on an intensity signal representing the intensity of light output from the detection device in addition to the position signal.

It is preferable that the mirror is swingable around a first axis and a second axis that are orthogonal to each other, and that the detection device detects a two-dimensional position of the incidence light.

An abnormality detection method of the present disclosure is an abnormality detection method of an optical scanning device including a micromirror device including a mirror that has a reflecting surface for reflecting light and is swingable around at least one axis, and an actuator that allows the mirror to swing, and a control device configured to control an operation of the actuator, the method comprising: irradiating a back surface of the mirror on a side opposite to the reflecting surface with illumination light; and detecting an abnormal operation of the mirror based on a temporal fluctuation amount of a position of reflected light of the illumination light that has been reflected by the mirror.

According to the technology of the present disclosure, it is possible to provide an optical scanning device and an abnormality detection method with which an abnormal operation of a mirror can be detected at high speed during the operation.

BRIEF DESCRIPTION OF THE DRAWINGS

Fig. 1 is a schematic diagram of an optical scanning device.
Fig. 2 is a schematic diagram of a micromirror device.
Fig. 3 is a diagram showing a first deflection angle of a movable mirror.
Fig. 4 is a diagram showing a second deflection angle of the movable mirror.
Fig. 5 is a diagram showing an example of a driving signal applied to a first actuator and a second actuator.
Fig. 6 is a schematic diagram showing an example of a configuration of an angle detection device.
Fig. 7 is a block diagram showing an example of a configuration of an abnormality detection device.
Fig. 8 is a diagram schematically showing an example of an output signal, a delay signal, and a fluctuation amount in a case in which the movable mirror is normally operated.
Fig. 9 is a diagram schematically showing an example of an output signal, a delay signal, and a fluctuation amount in a case in which an abnormal operation occurs in the movable mirror.
Fig. 10 is a diagram showing an example of a position signal and an intensity signal output from a detection device.
Fig. 11 is a diagram showing an example of an optical method.
Fig. 12 is a diagram showing an evaluation result.
Fig. 13 is a diagram showing a waveform of a fluctuation amount in a case in which $\Delta t/T = 0.5\%$.
Fig. 14 is a diagram showing a waveform of a fluctuation amount in a case in which $\Delta t/T = 5\%$.
Fig. 15 is a diagram showing a waveform of a fluctuation amount in a case in which $\Delta t/T = 0.01\%$.

Fig. 16 is a diagram showing a determination example by a determination method in the related art based on a position signal.
Fig. 17 is a diagram showing a determination example by a determination method in the related art based on a position signal.
Fig. 18 is a block diagram showing a configuration of an abnormality detection device according to a modification example.
Fig. 19 is a diagram showing an example of a determination method based on an intensity signal.

DESCRIPTION OF THE PREFERRED EMBODIMENTS

An example of an embodiment relating to the technology of the present disclosure will be described with reference to the accompanying drawings.

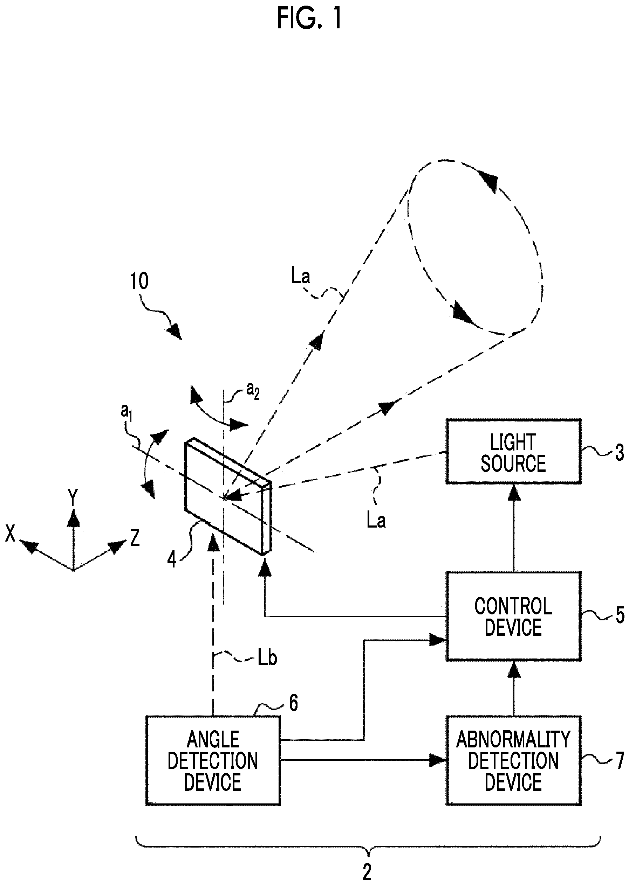

Fig. 1 schematically shows an optical scanning system 10 according to an embodiment. The optical scanning system 10 includes an optical scanning device 2 and a light source 3. The optical scanning device 2 includes a micromirror device (hereinafter, referred to as a micro mirror device (MMD)) 4, a control device 5, an angle detection device 6, and an abnormality detection device 7. The optical scanning system 10 is used in a laser scanner such as LiDAR or HUD.

The optical scanning device 2 performs optical scanning by reflecting laser light La incident from the light source 3 by the MMD 4 under a control of the control device 5. In a case in which the optical scanning system 10 is used in LiDAR, the optical scanning device 2 performs scanning with, for example, the laser light La in a helical shape. In the present embodiment, an optical scanning pattern is helical, but the optical scanning pattern is not limited to the helical shape and may be a Lissajous shape, a raster shape, or the like.

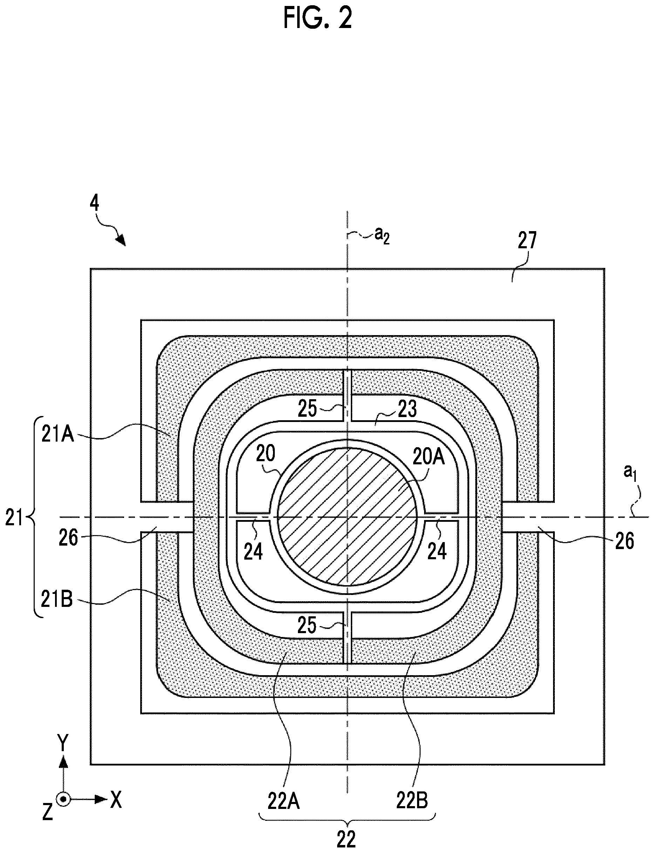

The MMD 4 is a piezoelectric biaxial drive type micromirror device capable of allowing a movable mirror 20 (see Fig. 2) to swing around a first axis $a_1$ and a second axis $a_2$ orthogonal to the first axis $a_1$. Hereinafter, a direction parallel to the first axis $a_1$ is referred to as an X direction, a direction parallel to the second axis $a_2$ is referred to as a Y direction, and a direction orthogonal to the first axis $a_1$ and the second axis $a_2$ is referred to as a Z direction.

The light source 3 is a laser device that emits the laser light La. The light source 3 emits the laser light La perpendicularly to a reflecting surface 20A (see Fig. 2) included in the movable mirror 20 in a state in which the movable mirror 20 of the MMD 4 is stationary. The laser light La is an example of "light" according to the technology of the present disclosure.

The control device 5 inputs a driving signal to the light source 3 and the MMD 4. The light source 3 generates the laser light L based on the input driving signal and emits the laser light La to the MMD 4. The MMD 4 allows the movable mirror 20 to swing around the

first axis $a_1$ and the second axis $a_2$ based on the input driving signal.

The details will be described below, and the control device 5 causes the movable mirror 20 to resonate around the first axis $a_1$ and the second axis $a_2$. Thereby, a plane is scanned with the laser light La reflected by the movable mirror 20 such that a circle is drawn on the plane.

As will be described in detail below, the angle detection device 6 irradiates a back surface side of the movable mirror 20 (that is, a side opposite to a surface on which the laser light La is emitted) with illumination light Lb for angle detection, thereby detecting an angle of the movable mirror 20. The detection operation of the angle detection device 6 is controlled by the control device 5. For example, the control device 5 performs a feedback control of correcting the driving signal based on a signal output from the angle detection device 6.

Details will be described later, but the abnormality detection device 7 detects an abnormal operation of the movable mirror 20 during operation based on a temporal fluctuation amount of a signal output from the angle detection device 6.

Next, an example of a configuration of the MMD 4 will be described with reference to Fig. 2. Fig. 2 is a schematic diagram of the MMD 4.

The MMD 4 has a movable mirror 20, a first actuator 21, a second actuator 22, a support frame 23, a first support portion 24, a second support portion 25, a connecting portion 26, and a fixed portion 27. The MMD 4 is formed, for example, by performing an etching treatment on a silicon on insulator (SOI) substrate. The movable mirror 20 is an example of a "mirror" according to the technology of the present disclosure.

The movable mirror 20 has a reflecting surface 20A for reflecting incidence light. The reflecting surface 20A is provided on one surface of the movable mirror 20, and is formed of a metal thin film such as gold (Au) and aluminum (Al). The reflecting surface 20A is, for example, circular.

The support frame 23 is disposed to surround the movable mirror 20. The second actuator 22 is disposed to surround the movable mirror 20 and the support frame 23. The first actuator 21 is disposed to surround the movable mirror 20, the support frame 23, and the second actuator 22.

The first support portion 24 connects the movable mirror 20 and the support frame 23 on the first axis $a_1$, and swingably supports the movable mirror 20 around the first axis $a_1$. The first axis $a_1$ is located in a plane including the reflecting surface 20A in a case in which the movable mirror 20 is stationary. For example, the first support portion 24 is a torsion bar stretched along the first axis $a_1$.

The second support portion 25 connects the support frame 23 and the second actuator 22 on the second axis $a_2$, and swingably supports the movable mirror 20 and the support frame 23 around the second

axis $a_2$. The second axis $a_2$ is orthogonal to the first axis $a_1$ in the plane including the reflecting surface 20A in a case in which the movable mirror 20 is stationary.

The connecting portion 26 connects the first actuator 21 and the second actuator 22 on the first axis $a_1$. In addition, the connecting portion 26 connects the first actuator 21 and the fixed portion 27 on the first axis $a_1$.

The fixed portion 27 has a rectangular outer shape and surrounds the first actuator 21. Lengths of the fixed portion 27 in the X direction and the Y direction are, for example, about 1 mm to 10 mm, respectively. A thickness of the fixed portion 27 in the Z direction is, for example, about 5 $\mu$m to 0.2 mm.

The first actuator 21 and the second actuator 22 are piezoelectric actuators each comprising a piezoelectric element. The first actuator 21 applies rotational torque around the first axis $a_1$ to the movable mirror 20. The second actuator 22 applies rotational torque around the second axis $a_2$ to the movable mirror 20. Thereby, the movable mirror 20 swings around the first axis $a_1$ and around the second axis $a_2$.

The first actuator 21 is an annular thin plate member that surrounds the movable mirror 20, the support frame 23, and the second actuator 22 in the XY plane. The first actuator 21 is composed of a pair of a first movable portion 21A and a second movable portion 21B. Each of the first movable portion 21A and the second movable portion 21B is substantially semi-annular. The first movable portion 21A and the second movable portion 21B have a shape that is line-symmetrical with respect to the first axis $a_1$, and are connected on the first axis $a_1$.

The support frame 23 is an annular thin plate member that surrounds the movable mirror 20 in the XY plane.

The second actuator 22 is an annular thin plate member that surrounds the movable mirror 20 and the support frame 23 in the XY plane. The second actuator 22 is composed of a pair of a first movable portion 22A and a second movable portion 22B. Each of the first movable portion 22A and the second movable portion 22B is semi-annular. The first movable portion 22A and the second movable portion 22B have a shape that is line-symmetrical with respect to the second axis $a_2$, and are connected on the second axis $a_2$.

In the first actuator 21, the first movable portion 21A and the second movable portion 21B are each provided with a piezoelectric element. In addition, in the second actuator 22, the first movable portion 22A and the second movable portion 22B are each provided with a piezoelectric element.

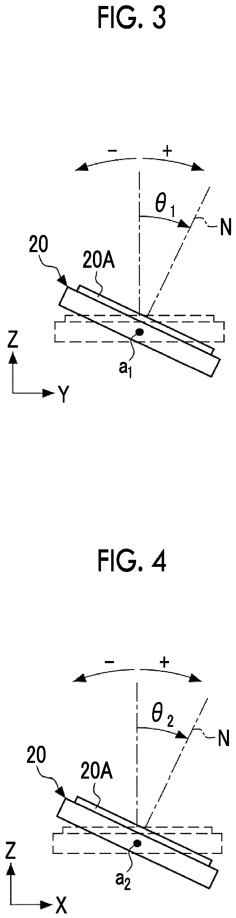

Fig. 3 and Fig. 4 show a deflection angle in a case in which the movable mirror 20 swings. Fig. 3 shows a deflection angle (hereinafter, referred to as a first deflection angle) $\theta_1$ of the movable mirror 20 around the first axis $a_1$. Fig. 4 shows a deflection angle (hereinafter, referred to as a second deflection angle) $\theta_2$ of the mo-

vable mirror 20 around the second axis $a_2$.

As shown in Fig. 3, an angle at which a normal line N of the reflecting surface 20A of the movable mirror 20 is inclined in the YZ plane is called a first deflection angle $\theta_1$. In a case in which the normal line N of the reflecting surface 20A is inclined in the +Y direction, the first deflection angle $\theta_1$ takes a positive value, and in a case in which it is inclined in the -Y direction, the first deflection angle $\theta_1$ takes a negative value.

The first deflection angle $\theta_1$ is controlled by the driving signal (hereinafter, referred to as a first driving signal) applied to the first actuator 21 by the control device 5. The first driving signal is, for example, a sinusoidal AC voltage. The first driving signal includes a driving voltage waveform $V_{1A}$ (t) applied to the first movable portion 21A and a driving voltage waveform $V_{1B}$ (t) applied to the second movable portion 21B. The driving voltage waveform $V_{1A}$ (t) and the driving voltage waveform $V_{1B}$ (t) are in an anti-phase with each other (that is, a phase difference is 180°).

As shown in Fig. 4, an angle at which a normal line N of the reflecting surface 20A of the movable mirror 20 is inclined in the XZ plane is called a second deflection angle $\theta_2$. In a case in which the normal line N of the reflecting surface 20A is inclined in the +X direction, the second deflection angle $\theta_2$ takes a positive value, and in a case in which it is inclined in the -X direction, the second deflection angle $\theta_2$ takes a negative value.

The second deflection angle $\theta_2$ is controlled by the driving signal (hereinafter, referred to as a second driving signal) applied to the second actuator 22 by the control device 5. The second driving signal is, for example, a sinusoidal AC voltage. The second driving signal includes a driving voltage waveform $V_{2A}$ (t) applied to the first movable portion 22A and a driving voltage waveform $V_{2B}$ (t) applied to the second movable portion 22B. The driving voltage waveform $V_{2A}$ (t) and the driving voltage waveform $V_{2B}$ (t) are in an anti-phase with each other (that is, the phase difference is 180°).

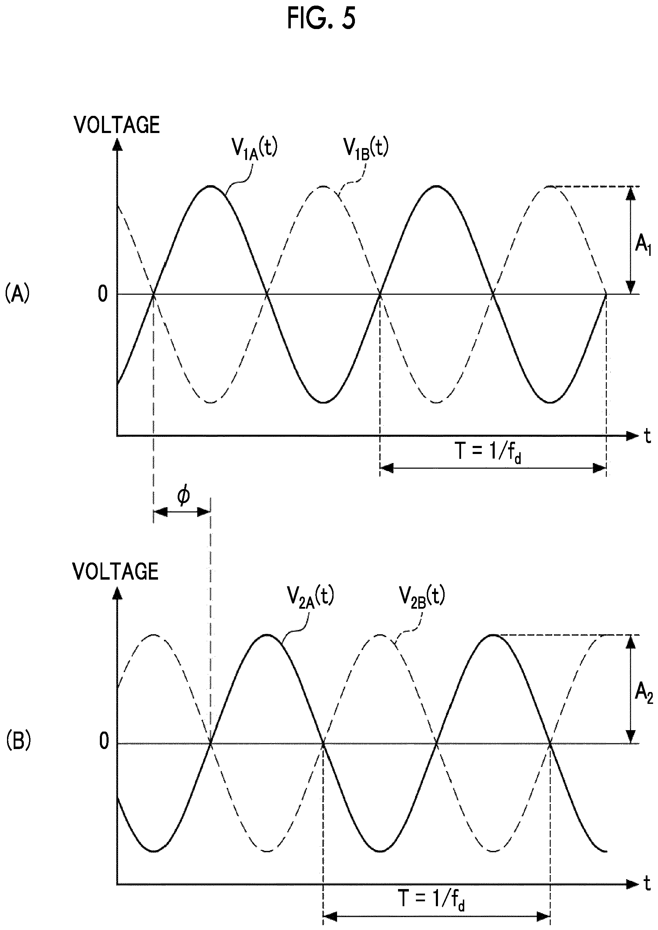

Fig. 5 shows an example of a driving signal applied to the first actuator 21 and the second actuator 22. (A) of Fig. 5 shows the driving voltage waveforms $V_{1A}$ (t) and $V_{1B}$ (t) included in the first driving signal. (B) of Fig. 5 shows the driving voltage waveforms $V_{2A}$ (t) and $V_{2B}$ (t) included in the second driving signal.

The driving voltage waveforms $V_{1A}$ (t) and $V_{1B}$ (t) are represented by Equations (1A) and (1B), respectively.

$$V_{1A} (t) = A_1 \sin(2\pi f_d t) \ ... \ (1A)$$

$$V_{1B} (t) = A_1 \sin(2\pi f_d t + \pi) \ ... \ (1B)$$

Here, t is a time. $f_d$ is a driving frequency. $A_1$ is an amplitude. A phase difference between the driving voltage waveform $V_{1A}$ (t) and the driving voltage waveform $V_{1B}$ (t) is $\pi$ (that is, 180°).

The driving voltage waveforms $V_{2A}$ (t) and $V_{2B}$ (t) are represented by Equations (2A) and (2B), respectively.

$$V_{2A} (t) = A_2 \sin(2\pi f_d t + \varphi) \ ... \ (2A)$$

$$V_{2B} (t) = A_2 \sin(2\pi f_d t + \pi + \varphi) \ ... \ (2B)$$

Here, $A_2$ is an amplitude. A phase difference between the driving voltage waveform $V_{2A}$ (t) and the driving voltage waveform $V_{2B}$ (t) is $\pi$ (that is, 180°). $\varphi$ is a phase difference between the driving voltage waveform $V_{1A}$ (t) and the driving voltage waveform $V_{2A}$ (t). In the present embodiment, $\varphi = 90°$ is set in order to cause the movable mirror 20 to perform precession to form the optical scanning pattern in a helical shape. Note that the amplitudes $A_1$ and $A_2$ may be changed in accordance with the time t.

In the present embodiment, the driving frequency $f_d$ is set as a resonance frequency of the movable mirror 20. Thereby, the movable mirror 20 resonates with a fixed swing period T. The swing period T is represented by $T = 1/f_d$.

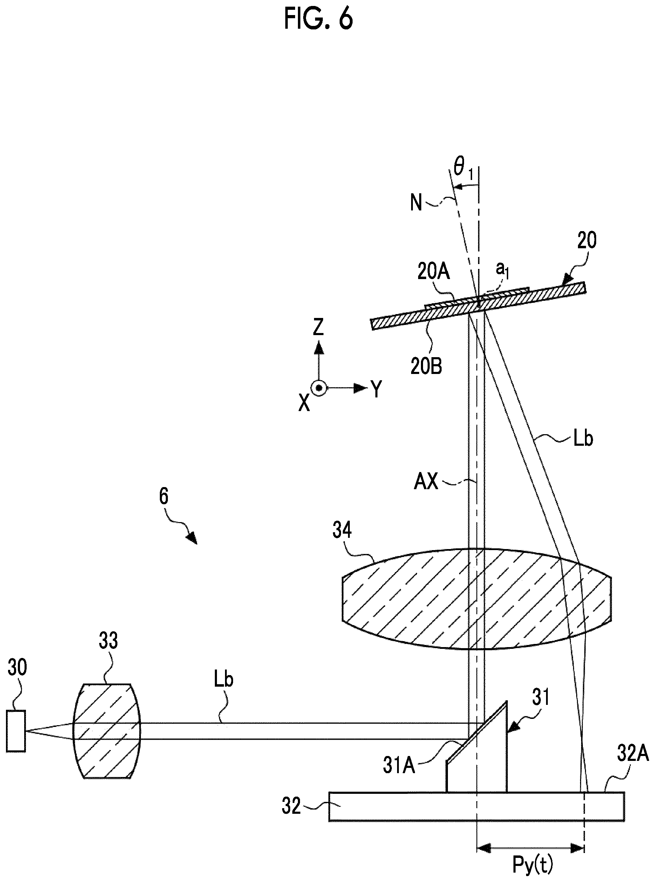

Fig. 6 shows an example of a configuration of the angle detection device 6. As shown in Fig. 6, the angle detection device 6 comprises a light irradiation device 30, a light deflection member 31, a detection device 32, a collimating lens 33, and a condenser lens 34. The light irradiation device 30 emits illumination light Lb for angle detection. For example, the light irradiation device 30 is a laser diode that emits laser light having a wavelength of about 980 nm as the illumination light Lb.

The light deflection member 31 has a cut surface formed by cutting a base material of a cylinder obliquely with respect to a rotational symmetry axis of the cylinder, and a reflecting surface 31A is formed on the cut surface. The light deflection member 31 is disposed such that the illumination light Lb emitted from the light irradiation device 30 is incident on the reflecting surface 31A at an incidence angle of about 45°.

The collimating lens 33 is disposed between the light irradiation device 30 and the light deflection member 31. The illumination light Lb emitted from the light irradiation device 30 is incident on the reflecting surface 31A via the collimating lens 33. A traveling direction of the illumination light Lb emitted from the light irradiation device 30 is, for example, the Y direction. The illumination light Lb incident on the reflecting surface 31A travels in the Z direction by being deflected by an angle of 90°, and is incident on a back surface 20B of the movable mirror 20. The back surface 20B is a surface opposite to the surface of the movable mirror 20 on which the reflecting surface 20A is provided. Although not shown, a beam structure (also referred to as a rib) is provided on the back surface 20B in order to enhance the strength of the movable mirror 20.

The condenser lens 34 is disposed between the light deflection member 31 and the movable mirror 20. The condenser lens 34 is, for example, a biconvex lens, and is disposed such that the illumination light Lb deflected by the light deflection member 31 travels along an optical axis AX thereof. The illumination light Lb passes through the center of the condenser lens 34 and is incident on the back surface 20B of the movable mirror 20.

The illumination light Lb incident on the back surface 20B of the movable mirror 20 is reflected at a reflection angle corresponding to the deflection angle (first deflection angle $\theta_1$ and second deflection angle $\theta_2$) of the movable mirror 20. The illumination light Lb that has been reflected by the back surface 20B of the movable mirror 20 is incident on a light-receiving surface 32A of the detection device 32 via the condenser lens 34. The light deflection member 31 is disposed at the center of the light-receiving surface 32A.

The detection device 32 is a position sensitive detector capable of detecting a light quantity centroid position of the incidence light, and outputs a position signal representing the light quantity centroid position. In the present embodiment, as the detection device 32, a two-dimensional position sensitive detector (PSD) that detects a two-dimensional position of the incidence light is used. The detection device 32 detects the light quantity centroid position in the X direction and the light quantity centroid position in the Y direction, of the incidence light on the light-receiving surface 32A. The detection device 32 outputs a position signal Px (t) representing the light quantity centroid position in the X direction and a position signal Py (t) representing the light quantity centroid position in the Y direction. As shown in Fig. 6, the position signal Py (t) changes in accordance with the first deflection angle $\theta_1$. Although not shown, the position signal Px (t) changes in accordance with the second deflection angle $\theta_2$.

The detection device 32 of the present embodiment makes it possible to simultaneously detect the light quantity centroid position and an intensity of light of the incidence light, and outputs intensity signals Ix (t) and Iy (t) representing the intensity of the incidence light in addition to the position signals Px (t) and Py (t). The intensity signal Ix (t) represents the intensity of light in the X direction. The intensity signal Iy (t) represents the intensity of light in the Y direction.

The control device 5 performs a feedback control of correcting the first driving signal and the second driving signal based on the position signals Px (t) and Py (t) output from the angle detection device 6.

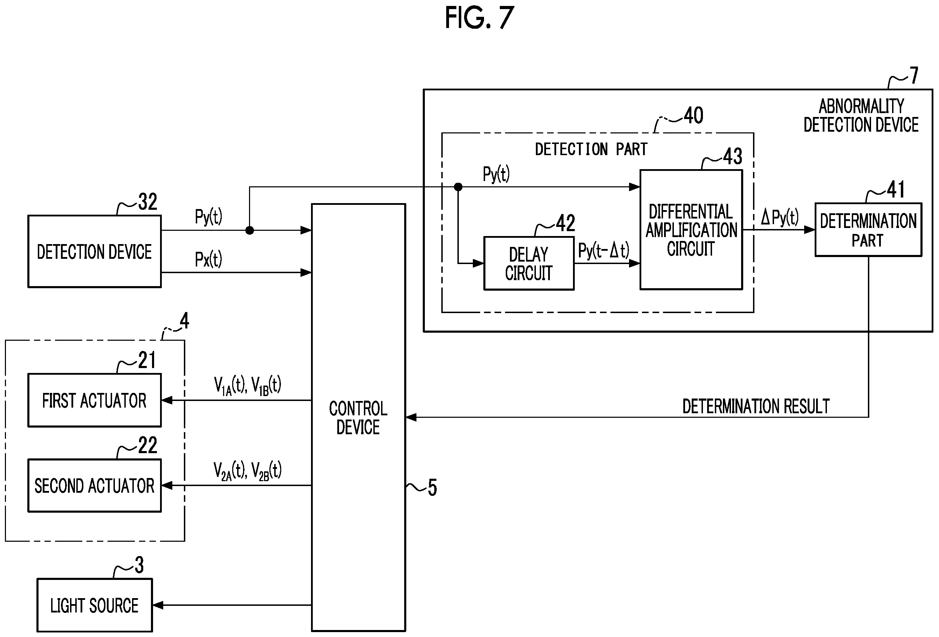

Fig. 7 shows an example of a configuration of the abnormality detection device 7. The abnormality detection device 7 includes a detection part 40 and a determination part 41. The detection part 40 is composed of a delay circuit 42 and a differential amplification circuit 43. In the present embodiment, the abnormality detection device 7 performs abnormality detection using the position signal Py (t) out of the position signals Px (t) and Py (t) output from the detection device 32.

The position signal Py (t) is input to the detection part 40. Specifically, the position signal Py (t) is input to the delay circuit 42 and the differential amplification circuit 43. The delay circuit 42 delays the input position signal Py (t) by a certain period of time Δt and outputs the signal. Hereinafter, the signal output from the delay circuit 42 is referred to as a delay signal Py (t - Δt). Hereinafter, the time Δt is referred to as a delay time Δt. The delay time Δt is shorter than the swing period T.

The delay signal Py (t - Δt) output from the delay circuit 42 is input to the differential amplification circuit 43. The differential amplification circuit 43 amplifies and outputs a difference between the position signal Py (t) and the delay signal Py (t - Δt). That is, the delay circuit 42 adjusts a phase of the position signal Py (t) to obtain the delay signal Py (t - Δt). Hereinafter, the output signal output from the differential amplification circuit 43 is referred to as a fluctuation amount ΔPy (t). The fluctuation amount ΔPy (t) represents a temporal fluctuation amount of the position signal Py (t). In other words, the fluctuation amount ΔPy (t) represents an amount by which the position signal Py (t) fluctuates in a time interval smaller than the swing period T.

The fluctuation amount ΔPy (t) output from the differential amplification circuit 43 is input to the determination part 41. The determination part 41 is composed of a comparator. The determination part 41 determines whether or not the fluctuation amount ΔPy (t) is equal to or greater than a threshold value Vth, and outputs a determination result to the control device 5. Here, the fact that the fluctuation amount ΔPy (t) is equal to or greater than the threshold value Vth means that an absolute value of the fluctuation amount ΔPy (t) is equal to or greater than the threshold value Vth, in other words, ΔPy (t) ≥ Vth, or ΔPy (t) ≤ -Vth.

The control device 5 stops the operations of the light source 3 and the MMD 4 according to the determination result output from the determination part 41. Specifically, the control device 5 stops the operations of the light source 3 and the MMD 4 in a case in which the determination part 41 determines that the fluctuation amount ΔPy (t) is equal to or greater than the threshold value Vth.

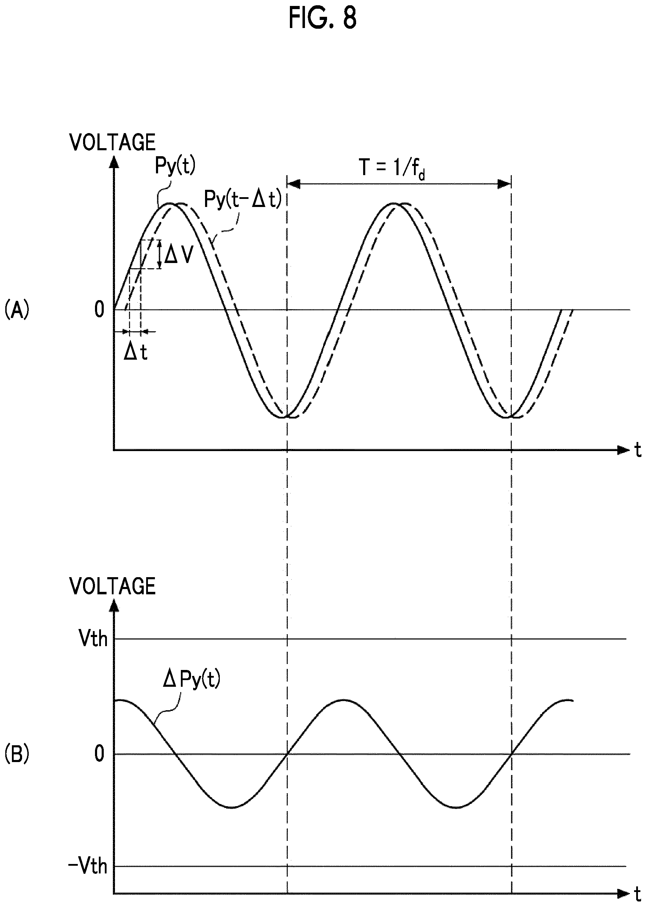

Fig. 8 schematically shows an example of the position signal Py (t), the delay signal Py (t - Δt), and the fluctuation amount ΔPy (t) in a case in which the movable mirror 20 is normally operated. (A) of Fig. 8 shows an example of the position signal Py (t) and the delay signal Py (t - Δt). (B) of Fig. 8 shows an example of the fluctuation amount ΔPy (t).

In a case in which the movable mirror 20 resonates with a fixed swing period T, the position signal Py (t) ideally becomes a substantially sinusoidal wave, as shown in (A) of Fig. 8. In (A) of Fig. 8, the position signal Py (t) is shown by a solid line, and the delay signal Py (t - Δt) is shown by a broken line. The fluctuation amount ΔPy (t) shown in (B) of Fig. 8 corresponds to a fluctuation

voltage $\Delta V$ of the position signal Py (t) with respect to the delay time $\Delta t$. The fluctuation amount $\Delta Py$ (t) ideally becomes a substantially sinusoidal wave.

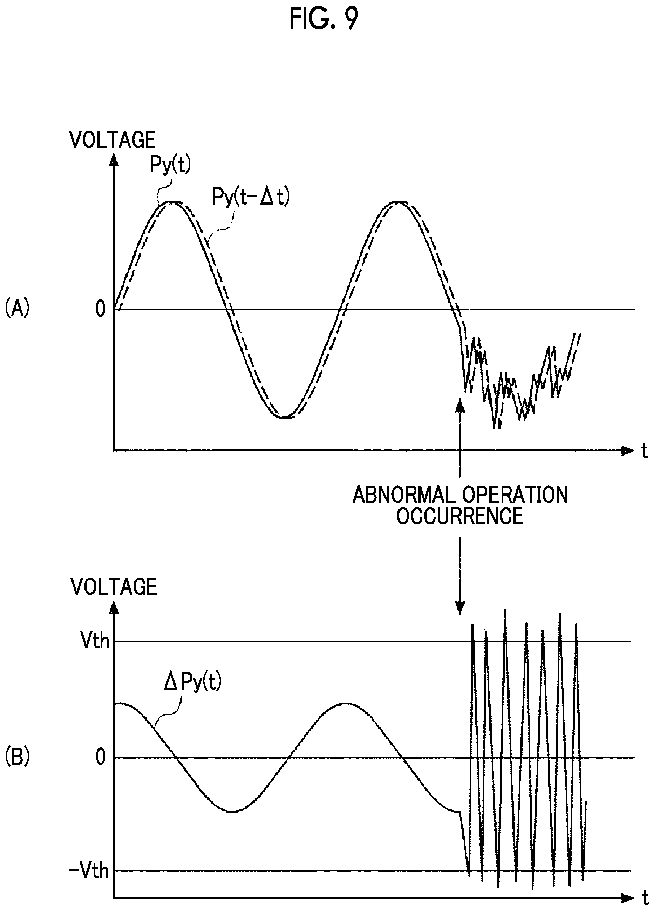

Fig. 9 schematically shows an example of the position signal Py (t), the delay signal Py (t - $\Delta t$), and the fluctuation amount $\Delta Py$ (t) in a case in which an abnormal operation occurs in the movable mirror 20. (A) of Fig. 9 shows an example of the position signal Py (t) and the delay signal Py (t - $\Delta t$). (B) of Fig. 9 shows an example of the fluctuation amount $\Delta Py$ (t).

As shown in Fig. 9, in a case in which an abnormal operation occurs in the movable mirror 20, the fluctuation amount $\Delta Py$ (t) greatly changes to be equal to or greater than the threshold value Vth, and the determination part 41 determines that the operation of the movable mirror 20 is abnormal.

Even in a case in which the operation of the movable mirror 20 is normal, noise may be generated in a waveform of the position signal Py (t) because of stray light or the like being included in the reflected light from the back surface 20B of the movable mirror 20. The stray light is caused, for example, by the illumination light Lb being reflected by a beam structure or the like provided on the back surface 20B. In order to accurately detect the abnormal operation of the movable mirror 20 regardless of the influence of noise or the like, it is necessary to set the delay time $\Delta t$ within an appropriate range. Specifically, it is preferable to set a ratio ($\Delta t/T$) of the delay time $\Delta t$ to the swing period T within an appropriate range.

For example, it is preferable to define an upper limit value to satisfy $\Delta t/T < 5\%$. In this case, the detection part 40 detects an amount by which the position signal Py (t) fluctuates in a time interval smaller than 5% of the swing period T, as the fluctuation amount $\Delta Py$ (t). In addition, it is more preferable to define an upper limit value and a lower limit value to satisfy $0.05\% < \Delta t/T < 5\%$. In this case, the detection part 40 detects an amount by which the position signal Py (t) fluctuates in a time interval smaller than 5% and greater than 0.05% of the swing period T, as the fluctuation amount $\Delta Py$ (t).

Verification of Effect by Experiment

By using the abnormality detection device 7 configured as described above, it is possible to detect the abnormal operation of the movable mirror 20 at high speed during the operation. In order to verify this effect, the present applicant manufactured a plurality of the MMD 4s and conducted an experiment.

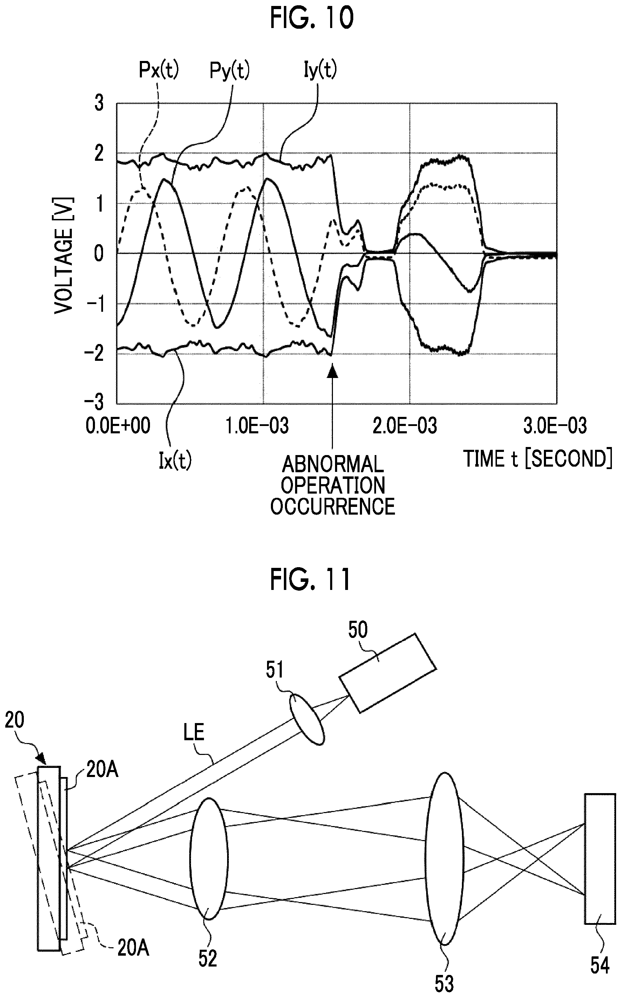

With the manufactured MMD 4 having a driving frequency $f_d$ of about 1420 Hz and the movable mirror 20 performing precession, the signals output from the detection device 32 were input to the abnormality detection device 7 to evaluate an accuracy of abnormality detection. The swing period T is about 704 $\mu$s. Fig. 10 shows an example of the position signals Px (t) and Py (t) and the intensity signals Ix (t) and Iy (t) output from the detection device 32. In this experiment, the position signal Py (t) was input to the abnormality detection device 7. The abnormality detection device 7 evaluated an accuracy of abnormality detection for a plurality of ratios $\Delta t/T$ by changing the delay time $\Delta t$.

In addition, since an abnormal operation is less likely to occur in a normal environment, an abnormal operation was caused to generate by operating the MMD 4 in a load environment. The load includes driving the MMD 4 in a high-temperature and high-humidity environment, applying an impact to the MMD 4 from an outside, and driving the MMD 4 with a high driving voltage.

A determination result of the abnormal operation based on a measured value obtained by directly measuring the operation of the movable mirror 20 by an optical method was used as an evaluation standard. Fig. 11 shows an example of the optical method. As shown in Fig. 11, evaluation laser light LE is emitted from an evaluation light source 50 to the reflecting surface 20A of the movable mirror 20 via a collimating lens 51, and reflected light from the reflecting surface 20A is formed into an image on a position sensitive detector (PSD) 54 via lenses 52 and 53. An image forming position obtained by the position sensitive detector is converted into a deflection angle of the movable mirror 20. In order to improve a conversion accuracy of the deflection angle, it is preferable that a reference mirror having a known angle is installed instead of the MMD 4 and that calibration for calibrating an angle and position information is executed.

The deflection angle (the first deflection angle $\theta_1$ and the second deflection angle $\theta_2$) of the movable mirror 20 was measured by the optical method described above, and a composite angle obtained by combining the first deflection angle $\theta_1$ and the second deflection angle $\theta_2$ was calculated. In a case in which the movable mirror 20 performs precession, the composite angle is constant. In a case in which the composite angle exceeds a range of $\pm 10\%$ from a steady-state value, it is determined that an abnormal operation has occurred, and a time at which the determination is made was used as a reference time.

The accuracy of abnormality detection by the abnormality detection device 7 was evaluated for a plurality of evaluation items. The evaluation items used in this experiment are "detection time", "detection omission", and "erroneous detection". The detection time is an evaluation item relating to a time at which an abnormal operation was detected (abnormality detection time). The detection omission is an evaluation item relating to whether or not an abnormal operation could be detected. The erroneous detection is an evaluation item relating to whether or not an abnormal operation was erroneously detected during a period from a start of the operation to the occurrence of the abnormal operation.

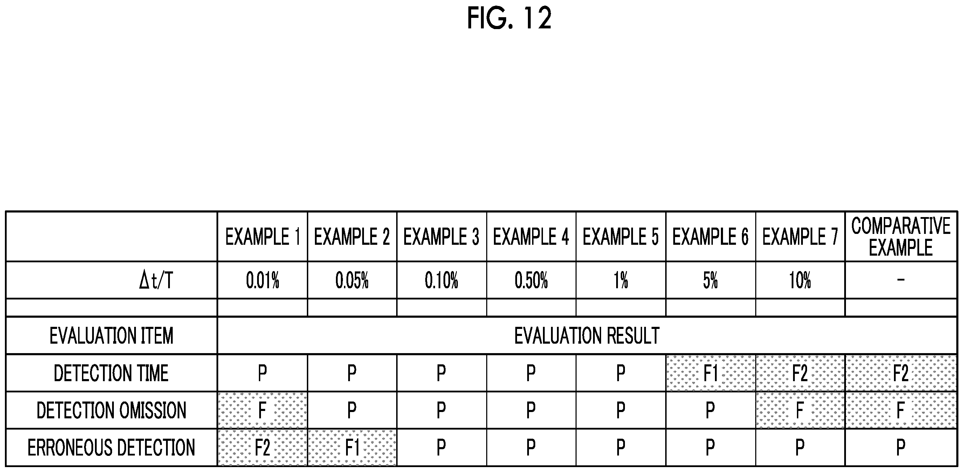

Fig. 12 shows an evaluation result. Examples 1 to 7 are experimental examples of abnormality detection using the abnormality detection device 7 of the present embodiment, in which the ratios $\Delta t/T$ are different from each other because of different set values of the delay time Δt. A comparative example is an experimental example of abnormality detection using the determination method in the related art based on the position signal Py (t) without using the abnormality detection device 7 of the present embodiment.

In the evaluation result of the detection time, P indicates that, as a result of conducting the experiment using 100 samples, the latest abnormality detection time (worst detection time) was less than 350 μs from the above-described reference time. F1 indicates that the worst detection time was less than 700 μs from the reference time. F2 indicates that the worst detection time was equal to or more than 700 μs from the reference time.

In the evaluation result of the detection omission, P indicates that, as a result of conducting the experiment using 100 samples, the abnormal operation could be detected for all the samples, that is, there was no detection omission. F indicates that the abnormal operation could not be detected for at least one sample, that is, there was a detection omission.

In the evaluation result of the erroneous detection, P indicates that, as a result of conducting the experiment using 100 samples, a value (erroneous detection rate) obtained by dividing the number of erroneously detected samples by the total number of the samples was less than 10%. F1 indicates that an erroneous detection rate was less than 50%. F2 indicates that an erroneous detection rate was equal to or more than 50%.

According to the evaluation result of the detection time, it can be seen that the worst detection time is less than 350 μs from the reference time in a case in which Δt/T < 5%. That is, it is preferable that Δt/T < 5% in order to detect the abnormal operation of the movable mirror 20 at high speed during the operation.

According to the evaluation result of the detection omission, it can be seen that the detection omission does not occur in a case in which 0.01% < Δt/T < 10%. That is, from the viewpoint of detection omission, it is preferable that the lower limit value of Δt/T is 0.01%.

According to the evaluation result of the erroneous detection, it can be seen that the erroneous detection does not occur in a case in which 0.05% < Δt/T. The erroneous detection is mainly caused by noise due to stray light. That is, from the viewpoint of noise immunity, it is preferable that the lower limit value of Δt/T is 0.05%.

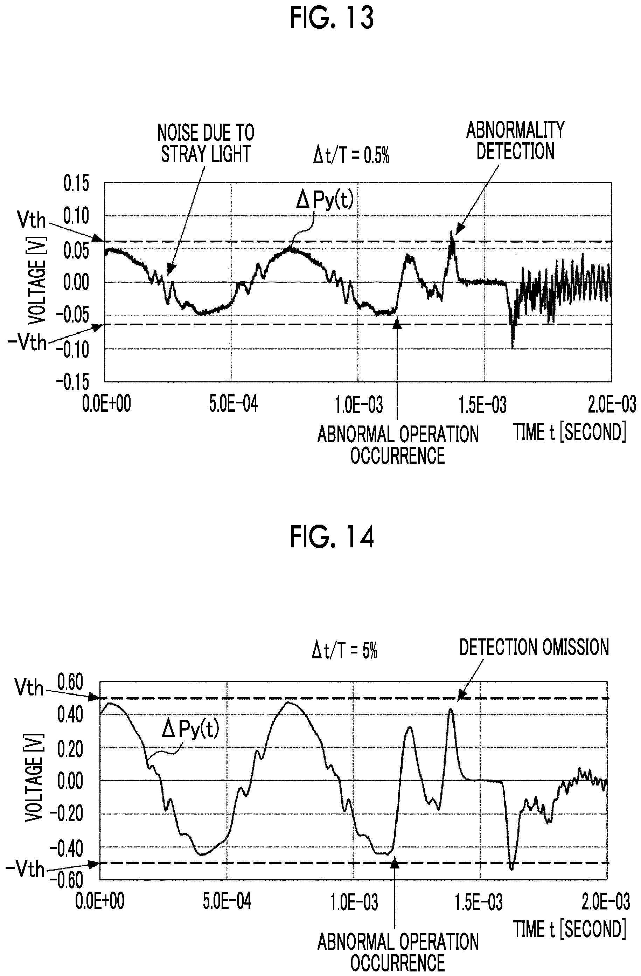

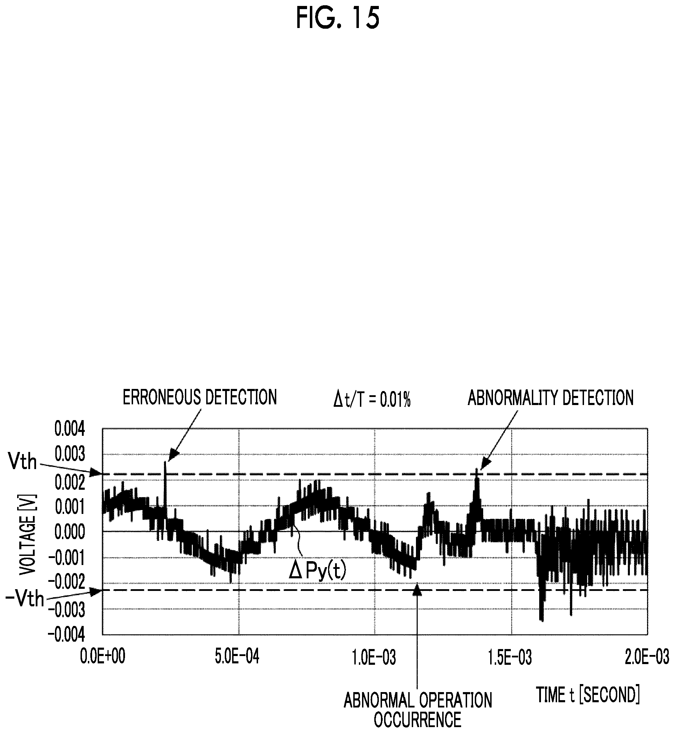

Figs. 13 to 15 show a waveform of the fluctuation amount ΔPy (t). Fig. 13 shows a waveform of the fluctuation amount ΔPy (t) in a case in which Δt/T = 0.5%. Fig. 14 shows a waveform of the fluctuation amount ΔPy (t) in a case in which Δt/T = 5%. Fig. 15 shows a waveform of the fluctuation amount ΔPy (t) in a case in which Δt/T = 0.01%.

Fig. 13 shows an example of a waveform that enables the abnormality detection at high speed and with high accuracy in a case in which 0.05% < Δt/T < 10%. In the waveform shown in Fig. 13, since the amplitude during the abnormal operation is larger than the amplitude during the normal operation, the abnormal operation can be detected at high speed and with high accuracy. In addition, Fig. 13 shows that even in a case in which noise due to stray light is mixed in the waveform, a relationship between the amplitudes is maintained, and the abnormal operation can be stably detected.

Fig. 14 shows an example of a waveform in which the detection omission occurs in a case in which Δt/T ≥ 5%. In the waveform shown in Fig. 14, since the amplitude during the abnormal operation is smaller than the amplitude during the normal operation, the abnormal operation cannot be detected, and the detection omission occurs.

Fig. 15 shows an example of a waveform in which the erroneous detection occurs in a case in which Δt/T ≤ 0.05%. Since the waveform shown in Fig. 15 has small amplitudes during the normal operation and the abnormal operation, it is susceptible to noise due to stray light, and the erroneous detection is likely to occur.

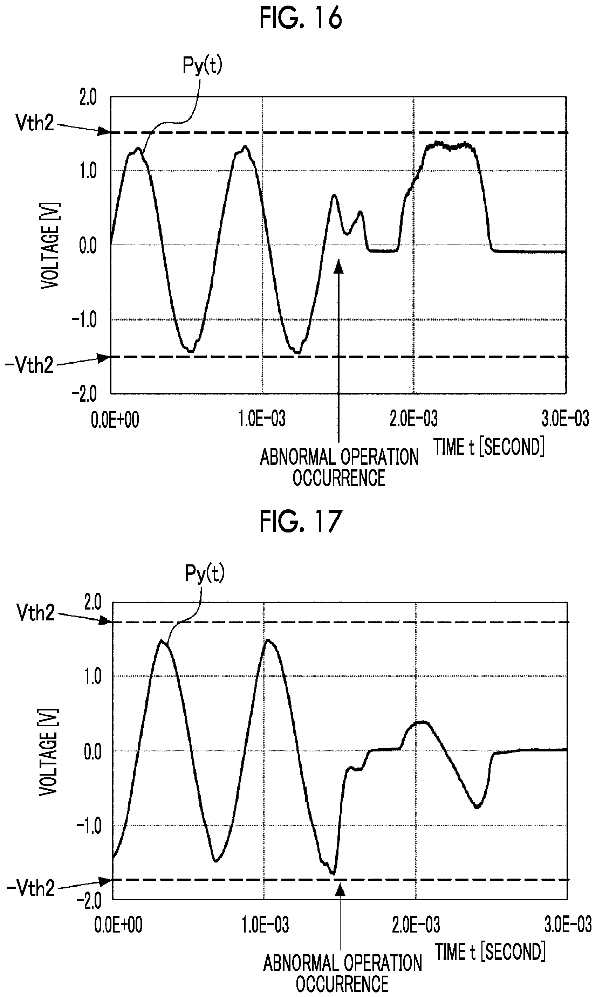

Fig. 16 and Fig. 17 show a determination example by the determination method in the related art based on the position signal Py (t). In the determination method in the related art, the abnormality detection is performed by comparing the position signal Py (t) with a threshold value Vth2. In each of the waveforms shown in Figs. 16 and 17, the amplitude decreases after the occurrence of the abnormal operation, and the abnormal operation cannot be detected, resulting in detection omission. In a case in which the amplitude increases after the occurrence of the abnormal operation, the abnormal operation is detected even by the determination method in the related art, but it takes a time for the position signal Py (t) to exceed the threshold value Vth2 after the occurrence of the abnormal operation. Therefore, the abnormality detection cannot be performed at high speed.

Various Modification Examples

In the above-described embodiment, although the abnormality detection device 7 performs the abnormality detection based on the position signal Py (t), the abnormality detection device 7 may perform the abnormality detection based on the position signal Px (t). In addition, the abnormality detection device 7 may perform the abnormality detection based on each of the position signals Py (t) and Px (t). In this case, for example, the abnormality detection device 7 determines that the abnormal operation has occurred in a case in which the temporal fluctuation amount of any one of the position signals Py (t) and Px (t) is equal to or greater than the threshold value.

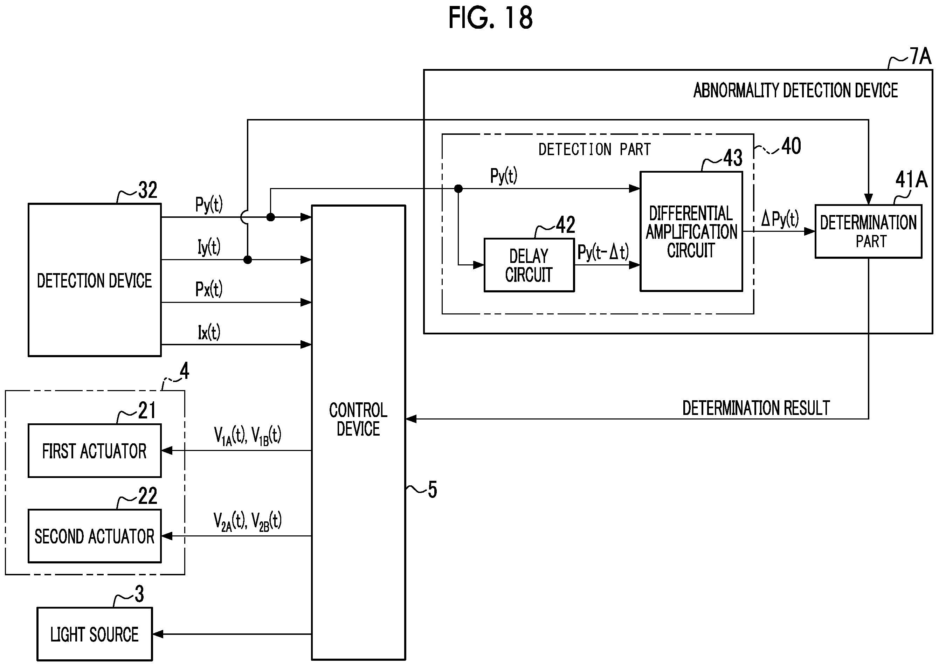

In addition, the abnormality detection device 7 may perform the abnormality detection based on the intensity signal in addition to the position signal. Fig. 18 shows a configuration of an abnormality detection device 7A according to a modification example. The abnormality detection device 7A performs the abnormality detection based on the intensity signal Iy (t) in addition to the position signal Py (t) output from the detection device 32. The abnormality detection device 7A includes a detection part 40 and a determination part 41A. The determination part 41A performs the above-described determination based on the fluctuation amount ∆Py (t) of the position signal Py (t), and also performs the determination based on the intensity signal Iy (t).

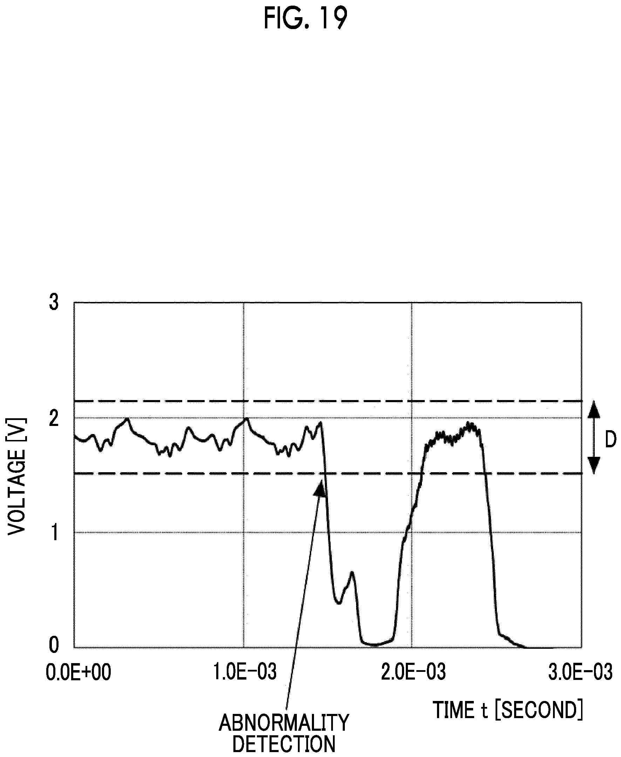

Fig. 19 shows an example of a determination method based on the intensity signal Iy (t). Although the intensity signal Iy (t) fluctuates within a certain range D in a case in which the movable mirror 20 performs a normal operation, the intensity signal Iy (t) falls outside the certain range D in a case in which an abnormal operation occurs in the movable mirror 20. Therefore, the determination part 41A monitors the intensity signal Iy (t), and determines that the abnormal operation has occurred in a case in which the intensity signal Iy (t) falls outside the certain range D. In this way, by performing the abnormality detection based on the intensity signal in addition to the position signal, the accuracy of the abnormality detection is further improved.

The abnormality detection may be performed based on all of the position signals Px (t) and Py (t) and the intensity signals Ix (t) and Iy (t).

In the above-described embodiment, although the detection part 40 is composed of the delay circuit 42 and the differential amplification circuit 43, the detection part 40 may be composed of a differential circuit. In addition, the detection part 40 may be composed of a high-pass filter. In this case, a cutoff frequency of the high-pass filter need only be set in accordance with the upper limit value of ∆t/T. In addition, the detection part 40 may be composed of a band-pass filter. In this case, cutoff frequencies on a high frequency side and a low frequency side of the band-pass filter need only be set in accordance with the lower limit value and the upper limit value of ∆t/T.

In addition, in the above-described embodiment, although the abnormality detection device 7 is composed of an analog circuit, a part or entirety of the abnormality detection device 7 may be composed of a digital circuit. For example, a signal obtained by digitizing the position signal Py (t) with an analog to digital converter (ADC) may be processed by software (program). In this case, a general-purpose processor can be used as the abnormality detection device 7. The general-purpose processor includes a central processing unit (CPU), a programmable logic device (PLD), a dedicated electric circuit, or the like. The processor performs detection processing and determination processing.

In addition, in the above-described embodiment, although a micromirror device having a mirror swingable around two axes is used, the micromirror device may have a mirror swingable around one axis. That is, the micromirror device need only include a mirror swingable around at least one axis, and an actuator that allows the mirror to swing. The detection device is not limited to a device that detects a two-dimensional position of the incidence light, and may be a device that detects a one-dimensional position of the incidence light.

Explanation of References

> 2: optical scanning device
> 3: light source
> 4: micromirror device (MMD)
> 5: control device
> 6: angle detection device
> 7, 7A: abnormality detection device
> 10: optical scanning system
> 20: movable mirror
> 20A: reflecting surface
> 20B: back surface
> 21: first actuator
> 21A: first movable portion
> 21B: second movable portion
> 22: second actuator
> 22A: first movable portion
> 22B: second movable portion
> 23: support frame
> 24: first support portion
> 25: second support portion
> 26: connecting portion
> 27: fixed portion
> 30: light irradiation device
> 31: light deflection member
> 31A: reflecting surface
> 32: detection device
> 32A: light-receiving surface
> 33: collimating lens
> 34: condenser lens
> 40: detection part
> 41, 41A: determination part
> 42: delay circuit
> 43: differential amplification circuit
> 50: evaluation light source
> 51: collimating lens
> 52, 53: lens
> 54: position sensitive detector
> AX: optical axis
> LE: evaluation laser light
> La: laser light
> Lb: illumination light
> N: normal line

Claims

1. An optical scanning device (2) comprising:

    a micromirror device (4) including a mirror (20) that has a reflecting surface (20A) for reflecting light and is swingable around at least one axis, and an actuator (21, 22) that allows the mirror (20) to swing;
a control device (5) configured to control an operation of the actuator (21, 22), wherein the control device (5) causes the mirror (20) to resonate with a fixed swing period by driving the actuator (21, 22);
a light irradiation device (30) configured to irradiate a back surface (20B) of the mirror (20) on a side opposite to the reflecting surface (20A) with illumination light;
a detection device (32) to which reflected light of the illumination light that has been reflected by the mirror (20) is incident and configured to output a position signal representing a position of the incidence light; and
an abnormality detection device (7, 7A) configured to detect an abnormal operation of the mirror based on a temporal fluctuation amount of the position signal, wherein the abnormality detection device (7, 7A) includes a detection part (40) configured to detect the fluctuation amount and a determination part (41, 41A) configured to determine whether or not the fluctuation amount is equal to or greater than a threshold value, wherein the detection part (40) is configured of:

a delay circuit (42) that delays the position signal output from the detection device by a certain period of time, and
a differential amplification circuit (43) that amplifies and outputs a difference between the position signal output from the detection device (32) and the position signal delayed by the delay circuit (42).

2. The optical scanning device (2) according to claim 1,

wherein the detection device (32) is a position sensitive detector capable of detecting a light quantity centroid position of the incidence light, and
the position signal represents the light quantity centroid position.

3. The optical scanning device (2) according to claim 1, wherein the abnormality detection device (7, 7A) detects an amount by which the position signal fluctuates in a time interval smaller than 5% of the swing period, as the fluctuation amount.

4. The optical scanning device (2) according to claim 1, wherein the abnormality detection device (7, 7A) detects an amount by which the position signal fluctuates in a time interval smaller than 5% and larger than 0.05% of the swing period, as the fluctuation amount.

5. The optical scanning device (2) according to claim 1, wherein the determination part (41, 41A) is a comparator.

6. The optical scanning device (2) according to claim 2,

wherein the detection device (32) is a position sensitive detector capable of simultaneously detecting the light quantity centroid position and an intensity of light of the incidence light, and the abnormality detection device (7A) detects the abnormal operation based on an intensity signal representing the intensity of light output from the detection device (32) in addition to the position signal.

7. The optical scanning device (2) according to claim 1,

wherein the mirror (20) is swingable around a first axis and a second axis that are orthogonal to each other, and
the detection device (32) detects a two-dimensional position of the incidence light.

8. An abnormality detection method of the optical scanning device (2) of any preceding claim, the method comprising:

irradiating a back surface (20B) of the mirror (20) on a side opposite to the reflecting surface (20A) with illumination light; and
detecting an abnormal operation of the mirror (20) based on a temporal fluctuation amount of a position of reflected light of the illumination light that has been reflected by the mirror (20).

**Patentansprüche**

1. Optische Abtastvorrichtung (2), umfassend:

eine Mikrospiegelvorrichtung (4), die einen Spiegel (20), der eine Reflexionsfläche (20A) zum Reflektieren von Licht aufweist und um mindestens eine Achse schwenkbar ist, und einen Aktuator (21, 22), der es dem Spiegel (20) ermöglicht, zu schwingen, enthält;
eine Steuervorrichtung (5), die so konfiguriert ist, dass sie einen Betrieb des Aktuators (21, 22) steuert, wobei die Steuervorrichtung (5) durch Antreiben des Aktuators (21, 22) den Spiegel (20) veranlasst, mit einer fixierten Schwingperiode zu resonieren;
eine Lichtbestrahlungsvorrichtung (30), die so konfiguriert ist, dass sie eine Rückfläche (20B) des Spiegels (20) auf einer Seite, die der Reflexionsfläche (20A) gegenüberliegt, mit Beleuchtungslicht bestrahlt;

eine Detektionsvorrichtung (32), auf die reflektiertes Licht des Beleuchtungslichts, das von dem Spiegel (20) reflektiert wurde, einfällt und die so konfiguriert ist, dass sie ein Positionssignal, das eine Position des einfallenden Lichts darstellt, ausgibt; und

eine Abnormalitätsdetektionsvorrichtung (7, 7A), die so konfiguriert ist, dass sie eine abnormalen Betrieb des Spiegels auf der Grundlage eines zeitlichen Schwankungsbetrags des Positionssignals detektiert, wobei die Abnormalitätsdetektionsvorrichtung (7, 7A) einen Detektionsteil (40), der so konfiguriert ist, dass er den Schwankungsbetrag detektiert, und einen Bestimmungsteil (41, 41A), der so konfiguriert ist, dass er bestimmt, ob der Schwankungsbetrag gleich oder größer als ein Schwellenwert ist oder nicht, enthält, wobei der Detektionsteil (40) konfiguriert ist aus:

einer Verzögerungsschaltung (42), die das von der Detektionsvorrichtung ausgegebene Positionssignal um eine bestimmte Zeitspanne verzögert, und einer Differenzverstärkungsschaltung (43), die eine Differenz zwischen dem von der Detektionsvorrichtung (32) ausgegebenen Positionssignal und dem durch die Verzögerungsschaltung (42) verzögerten Positionssignal verstärkt und ausgibt.

2. Optische Abtastvorrichtung (2) nach Anspruch 1,

wobei die Detektionsvorrichtung (32) ein positionsempfindlicher Detektor ist, der in der Lage ist, eine Lichtmengen-Schwerpunktposition des einfallenden Lichts zu detektieren, und das Positionssignal den Lichtmengen-Schwerpunktposition darstellt.

3. Optische Abtastvorrichtung (2) nach Anspruch 1, wobei die Abnormalitätsdetektionsvorrichtung (7, 7A) einen Betrag, um den das Positionssignal in einem Zeitintervall schwankt, das kleiner als 5 % der Schwingperiode ist, als den Schwankungsbetrag detektiert.

4. Optische Abtastvorrichtung (2) nach Anspruch 1, wobei die Abnormalitätsdetektionsvorrichtung (7, 7A) einen Betrag, um den das Positionssignal in einem Zeitintervall schwankt, das kleiner als 5 % und größer als 0,05 % der Schwingperiode ist, als den Schwankungsbetrag detektiert.

5. Optische Abtastvorrichtung (2) nach Anspruch 1, wobei der Bestimmungsteil (41, 41A) ein Vergleicher ist.

6. Optische Abtastvorrichtung (2) nach Anspruch 2,

wobei die Detektionsvorrichtung (32) ein positionsempfindlicher Detektor ist, der in der Lage ist, die Lichtmengen-Schwerpunktposition und eine Intensität von Licht des einfallenden Lichts zu detektieren, und die Abnormalitätsdetektionsvorrichtung (7A) den abnormalen Betrieb auf der Grundlage eines Intensitätssignals, das die Intensität von von der Detektionsvorrichtung (32) abgegebenem Licht darstellt, zusätzlich zu dem Positionssignal, detektiert.

7. Optische Abtastvorrichtung (2) nach Anspruch 1,

wobei der Spiegel (20) um eine erste Achse und eine zweite Achse, die zueinander senkrecht sind, schwenkbar ist, und die Detektionsvorrichtung (32) eine zweidimensionale Position des einfallenden Lichts detektiert.

8. Abnormalitätsdetektionsverfahren der optischen Abtastvorrichtung (2) eines beliebigen der vorhergehenden Ansprüche, wobei das Verfahren umfasst:

Bestrahlen einer Rückfläche (20B) des Spiegels (20) auf einer Seite, die der Reflexionsfläche (20A) gegenüberliegt, mit Beleuchtungslicht; und Detektieren eines abnormalen Betriebs des Spiegels (20) auf der Grundlage eines zeitlichen Schwankungsbetrags einer Position von reflektiertem Licht des Beleuchtungslichts, das von dem Spiegel (20) reflektiert wurde.

**Revendications**

1. Dispositif de balayage optique (2) comprenant :

un dispositif à micromiroir (4) incluant un miroir (20) qui a une surface réfléchissante (20A) pour réfléchir de la lumière et qui est pivotant autour d'au moins un axe, et un actionneur (21, 22) qui permet au miroir (20) de pivoter ; un dispositif de contrôle (5) configuré pour contrôler un fonctionnement de l'actionneur (21, 22), dans lequel le dispositif de contrôle (5) amène le miroir (20) à résonner avec une période d'oscillation fixe en actionnant l'actionneur (21, 22) ; un dispositif d'irradiation de lumière (30) configuré pour irradier une surface arrière (20B) du miroir (20) sur un côté opposé à la surface réfléchissante (20A) avec une lumière d'illumination ;
un dispositif de détection (32) auquel de la lumière réfléchie de la lumière d'illumination, qui a été réfléchie par le miroir (20) est incidente et configuré pour émettre un signal de position représentant une position de la lumière incidente ; et
un dispositif de détection d'anomalie (7, 7A) configuré pour détecter un fonctionnement anormal du miroir sur la base d'une quantité de fluctuation temporelle du signal de position, dans lequel le dispositif de détection d'anomalie (7, 7A) inclut une partie de détection (40) configurée pour détecter la quantité de fluctuation et une partie de détermination (41, 41A) configurée pour déterminer si la quantité de fluctuation est égale ou supérieure à une valeur seuil, dans lequel la partie de détection (40) est configurée de :

un circuit de retard (42) qui retarde le signal de position émis par le dispositif de détection d'une certaine période de temps, et
un circuit d'amplification différentielle (43) qui amplifie et émet une différence entre le signal de position émis par le dispositif de détection (32) et le signal de position retardé par le circuit de retard (42).

2. Dispositif de balayage optique (2) selon la revendication 1,

dans lequel le dispositif de détection (32) est un détecteur sensible à la position capable de détecter une position de centroïde de quantité de lumière de la lumière incidente, et
le signal de position représente la position de centroïde de quantité de lumière.

3. Dispositif de balayage optique (2) selon la revendication 1,
dans lequel le dispositif de détection d'anomalie (7, 7A) détecte une quantité par laquelle le signal de position fluctue dans un intervalle de temps inférieur à 5 % de la période d'oscillation, en tant que quantité de fluctuation.

4. Dispositif de balayage optique (2) selon la revendication 1,
dans lequel le dispositif de détection d'anomalie (7, 7A) détecte une quantité par laquelle le signal de position fluctue dans un intervalle de temps inférieur à 5 % et supérieur à 0,05 % de la période d'oscillation, en tant que quantité de fluctuation.

5. Dispositif de balayage optique (2) selon la revendication 1,
dans lequel la partie de détermination (41, 41A) est un comparateur.

6. Dispositif de balayage optique (2) selon la revendication 2,

dans lequel le dispositif de détection (32) est un détecteur sensible à la position capable de détecter simultanément la position de centroïde de quantité de lumière et une intensité de lumière de la lumière incidente, et
le dispositif de détection d'anomalie (7A) détecte le fonctionnement anormal sur la base d'un signal d'intensité représentant l'intensité de lumière émise par le dispositif de détection (32) en plus du signal de position.

7. Dispositif de balayage optique (2) selon la revendication 1,

dans lequel le miroir (20) est pivotant autour d'un premier axe et d'un deuxième axe qui sont orthogonaux l'un à l'autre, et
le dispositif de détection (32) détecte une position bidimensionnelle de la lumière incidente.

8. Procédé de détection d'anomalie du dispositif de balayage optique (2) selon l'une des revendications précédentes, le procédé comprenant :

irradier une surface arrière (20B) du miroir (20) sur un côté opposé à la surface réfléchissante (20A) avec une lumière d'illumination ; et
détecter un fonctionnement anormal du miroir (20) sur la base d'une quantité de fluctuation temporelle d'une position de lumière réfléchie de la lumière d'illumination qui a été réfléchie par le miroir (20).

12

# FIG. 1

# FIG. 2

# FIG. 3

# FIG. 4

# FIG. 5

# FIG. 6

# FIG. 7

EP 4 270 085 B1

## FIG. 8

# FIG. 9

(A)

VOLTAGE

Py(t)

Py(t−Δt)

0

t

ABNORMAL OPERATION
OCCURRENCE

(B)

VOLTAGE

Vth

ΔPy(t)

0

−Vth

t

## FIG. 10

## FIG. 11

# FIG. 12

EP 4 270 085 B1

| | EXAMPLE 1 | EXAMPLE 2 | EXAMPLE 3 | EXAMPLE 4 | EXAMPLE 5 | EXAMPLE 6 | EXAMPLE 7 | COMPARATIVE EXAMPLE |
|---|---|---|---|---|---|---|---|---|
| $\Delta t/T$ | 0.01% | 0.05% | 0.10% | 0.50% | 1% | 5% | 10% | - |
| | | | | | | | | |
| EVALUATION ITEM | EVALUATION RESULT | | | | | | | |
| DETECTION TIME | P | P | P | P | P | F1 | F2 | F2 |
| DETECTION OMISSION | F | P | P | P | P | P | F | F |
| ERRONEOUS DETECTION | F2 | F1 | P | P | P | P | P | P |

## FIG. 13

## FIG. 14

# FIG. 15

## FIG. 16

ABNORMAL OPERATION
OCCURRENCE

## FIG. 17

ABNORMAL OPERATION
OCCURRENCE

## FIG. 18

# FIG. 19

ABNORMALITY
DETECTION

**REFERENCES CITED IN THE DESCRIPTION**

**Patent documents cited in the description**

- JP 2004170499 A
- JP 2004144926 A

- US 2006175544 A1